# EUROPEAN PATENT SPECIFICATION

(11) **EP 4 401 148 B1**
(45) Date of publication and mention of the grant of the patent: **11.11.2026**
(21) Application number: 24150687.2
(22) Date of filing: 08.01.2024
(51) Int. Cl.: H10D 30/47, H10D 64/23, H10D 62/85

(54) **SEMICONDUCTOR DEVICE**
HALBLEITERANORDNUNG
DISPOSITIF SEMI-CONDUCTEUR

(30) Priority: 13.01.2023 JP 2023004022
(43) Date of publication of application: 17.07.2024
(73) Proprietor: Sumitomo Electric Device Innovations, Inc., Yokohama-shi, Kanagawa, 224-0845 (JP)
(72) Inventor: MARUYAMA, Hiroaki, Yokohama-shi, Kanagawa, 244-0845 (JP)
(74) Representative: Grünecker Patent- und Rechtsanwälte PartG mbB

(56) References cited:
- WO-A1-2009/001888
- JP-A- 2019 121 785
- US-A1- 2018 204 940
- US-A1- 2022 140 123
- US-B2- 6 531 718
- CHA SUHYEONG ET AL: "Theoretical Study of Electron Transport Properties in GaN-Based HEMTs Using a Deterministic Multi-Subband Boltzmann Transport Equation Solver", IEEE TRANSACTIONS ON ELECTRON DEVICES, IEEE, USA, vol. 66, no. 9, 1 September 2019 (2019-09-01), pages 3740 - 3747, XP011741037, ISSN: 0018-9383, [retrieved on 20190820], DOI: 10.1109/TED.2019.2926857

## Description

### BACKGROUND

### 1. Field of the Invention

The present disclosure relates to semiconductor devices.

### 2. Description of the Related Art

US 6 531 718 B2 discloses a semiconductor device including a substrate, a buffer layer including GaN formed on the substrate, a separating layer formed on the buffer layer, a channel layer including GaN, InGaN or a combination of GaN and InGaN formed on the separating layer, and an AlGaN electron supply layer formed on the channel layer.
CHA SUHYEONG ET AL: "Theoretical Study of Electron Transport Properties in GaN-Based HEMTs Using a Deterministic Multi-Subband Boltzmann Transport Equation Solver", IEEE TRANSACTIONS ON ELECTRON DEVICES, IEEE, USA, vol. 66, no. 9, 1 September 2019 (2019-09-01), pages 3740-3747, ISSN: 0018-9383, DOI: 10.1109/TED.2019.2926857 discloses a 2-D high electron mobility transistor (HEMT) structure including a SiC substrate, a GaN buffer layer, an InGaN back barrier, a GaN channel layer, an AlN interlayer and an AlInN barrier layer.
US 2022/140123 A1 discloses a HEMT including a substrate, a buffer layer, a p-doped first GaN layer, a second GaN layer including no intentional doping, an AlGaN back barrier layer, a third GaN layer and a front barrier layer.
US 2018/204940 A1 discloses a HEMT with an AlN nucleation layer on a substrate, a GaN buffer layer on the nucleation layer, a doped AlGaN transition layer on the buffer layer, a doped AlGaN back-barrier layer on the transition layer, a GaN channel layer on the back-barrier layer and an unintentionally doped AlGaN top barrier on the channel layer. 1
JP 2019 121785 A discloses a HEMT with an AlN nucleation layer, two AlGaN buffer layers, an AlGaN back-barrier layer, a GaN channel layer, an AlGaN top barrier layer as well as an n-type AlGaN electron supply layer located on the top barrier layer in the source and drain region. An increase in transient response performance is desired in semiconductor devices with a high electron mobility transistor (HEMT) containing gallium nitride (GaN) (see, for example, Patent Documents 1 and 2).

### RELATED ART DOCUMENT

### PATENT DOCUMENT

Patent Document 1: Japanese Laid-open Patent Application Publication No. 2019-121785
Patent Document 2: Japanese Laid-open Patent Application Publication No. 2015-095605

### SUMMARY OF INVENTION

### TECHNICAL PROBLEM

A conceivable way of increasing transient response performance is to make an electron traveling layer thin. However, when the electron traveling layer is made thin, there is possibility of reduction in crystallinity of a channel region and an electron supply layer. Such reduction in crystallinity can lead to degradation in characteristics of electron mobility and the like.

It is an objective of the present disclosure to provide a semiconductor device that can be increased in transient response performance while avoiding reduction in crystallinity.

### SOLUTION TO PROBLEM

A semiconductor device according to the invention includes the features defined in claim 1. Embodiments include the features defined in the dependent claims.

### ADVANTAGEOUS EFFECTS OF THE INVENTION

According to the present disclosure, it is possible to increase transient response performance while avoiding reduction in crystallinity.

### BRIEF DESCRIPTION OF DRAWINGS

FIG. 1 is a cross-sectional view illustrating a semiconductor device comprising a layer structure according to the invention.
FIG. 2 is a band diagram comprising a layer structure according to the invention.
FIG. 3 is a cross-sectional view illustrating a semiconductor device according to a reference example, not falling under the scope of the claims.
FIG. 4 is a band diagram illustrating a band structure of an electron traveling layer, a spacer layer, an electron supply layer, and a cap layer in the reference example, not falling under the scope of the claims.

### DETAILED DESCRIPTION

### [Description of embodiments of the present disclosure]

First, embodiments of the present disclosure will be listed and described.

The invention is summarized by the appended set of claims. According to one aspect of the present invention the electron traveling layer is thinner than the buffer layer, and a band gap of the barrier layer is larger than a band gap of the buffer layer and a band gap of the electron traveling layer.

Because the band gap of the barrier layer is larger than the band gap of the buffer layer and the band gap of the electron traveling layer, negative polarization charges are present near the interface between the barrier layer and the electron traveling layer, and positive polarization charges are present near the interface between the barrier layer and the buffer layer. Also, in the electron traveling layer, the lower end of the conduction band is higher at a position closer to the barrier layer. Therefore, even if electrons in two-dimensional electron gas have high energy, the negative polarization charges prevent movement of the electrons in two-dimensional electron gas toward a deep position in the electron traveling layer. Therefore, even if a trap level is present in the electron traveling layer, the electrons are not readily trapped at the trap level, and it is possible to suppress reduction in transient response performance due to the trap of the electrons. Also, because the barrier layer can increase transient response performance, the buffer layer does not need to be made thin to an extent of causing reduction in crystallinity. Therefore, it is possible to increase transient response performance while avoiding reduction in crystallinity.

Both of the buffer layer and the electron traveling layer are a GaN layer, and the barrier layer is an AlₓIn_{y}Ga_{1-x-y}N layer (0 < x ≤ 1, 0 ≤ y ≤ 0.1). In this case, the band gap of the barrier layer more readily becomes larger than the band gap of the buffer layer and the band gap of the electron traveling layer.

A relation of "y + 0.8 ≤ x" may be established. In this case, polarization charges are more readily sufficiently obtained.

A thickness of the barrier layer may be 2 nm or larger and 20 nm or smaller. When the thickness of the barrier layer is 2 nm or larger, polarization charges are more readily sufficiently obtained. When the thickness of the barrier layer is 20 nm or smaller, the barrier layer is more readily pseudo-lattice matched with the buffer layer.

A thickness of the buffer layer is 200 nm or larger. When the thickness of the buffer layer is 200 nm or larger, favorable crystallinity is more readily obtained.

A thickness of the electron traveling layer is 400 nm or smaller. When the thickness of the electron traveling layer is 400 nm or smaller, the entirety of the electron traveling layer is more readily influenced by the polarization charges.

### [Details of embodiments of the present disclosure]

Hereinafter, embodiments of the present disclosure will be described in detail, with the present invention solely defined by the appended set of claims. Note that, in the present specification and the drawings, components having substantially the same functional configuration are given the same reference symbol, and description thereof may be omitted.

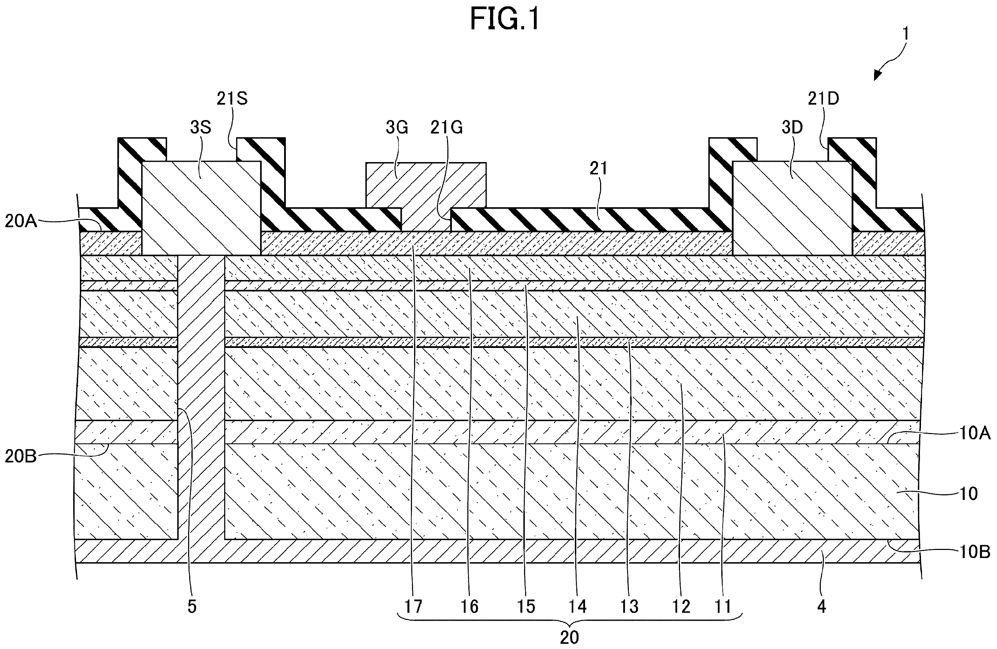

The embodiments relate to semiconductor devices including a gallium nitride-based high electron mobility transistor (GaN-HEMT) containing a nitride semiconductor as a main constituent material. FIG. 1 is a cross-sectional view illustrating a semiconductor device according to the embodiment.

As illustrated in FIG. 1, a semiconductor device 1 according to the embodiment includes a substrate 10, a stacked structure 20 of a plurality of semiconductor layers formed on or above the substrate 10, a gate electrode 3G, a source electrode 3S, a drain electrode 3D, and a rear-surface electrode 4. The substrate 10 includes an upper surface 10A and a lower surface 10B opposite to the upper surface 10A. The substrate 10 is, for example, a silicon carbide (SiC) substrate in which the plane orientation of the upper surface 10A is a (0001) plane. The stacked structure 20 is provided on the substrate 10. The stacked structure 20 includes an upper surface 20A and a lower surface 20B opposite to the upper surface 20A. The lower surface 20B is in direct contact with the upper surface 10A. The stacked structure 20 includes an initial layer 11, a buffer layer 12, a barrier layer 13, an electron traveling layer 14, a spacer layer 15, an electron supply layer 16, and a cap layer 17.

According to the invention, the initial layer 11 is provided on the substrate 10. The initial layer 11 is an aluminum nitride (AlN) layer having a thickness of 5 nm or larger and 100 nm or smaller. The buffer layer 12 is provided on the initial layer 11. The buffer layer 12 is an undoped gallium nitride (GaN) layer having a thickness of 200 nanometers (nm) or larger and 20 micrometers (µm) or smaller. The barrier layer 13 is provided on the buffer layer 12. The barrier layer 13 may be, for example, an undoped AlN layer having a thickness of 2 nm or larger and 20 nm or smaller. The electron traveling layer 14 is provided on the barrier layer 13. The electron traveling layer 14 is an undoped GaN layer having a thickness of 200 nm or larger and 400 nm or smaller. The spacer layer 15 is provided on the electron traveling layer 14. The spacer layer 15 is an undoped aluminum gallium nitride (AlGaN) layer having a thickness of 2 nm or larger and 10 nm or smaller. The electron supply layer 16 is provided on the spacer layer 15. The electron supply layer 16 is a n-type AlGaN layer having a thickness of 5 nm or larger and 28 nm or smaller. The sum of the thickness of the spacer layer 15 and the thickness of the electron supply layer 16 is, for example, 10 nm or larger and 30 nm or smaller. The cap layer 17 is provided on the electron supply layer 16. The cap layer 17 is, for example, a n-type GaN layer having a thickness of 1 nm or larger and 10 nm or smaller. The electron supply layer 16 and the cap layer 17 contain silicon (Si), germanium (Ge), or the like, as a n-type impurity. The stacking direction of the initial layer 11, the buffer layer 12, the barrier layer 13, the electron traveling layer 14, the spacer layer 15, the electron supply layer 16, and the cap layer 17 is, for example, the [0001] direction of SiC forming the substrate 10.

According to the invention, the electron traveling layer 14 is thinner than the buffer layer 12. Also, the band gap of the barrier layer 13 is larger than the band gap of the buffer layer 12 and the band gap of the electron traveling layer 14.

The source electrode 3S and the drain electrode 3D are formed on the electron supply layer 16. The source electrode 3S and the drain electrode 3D are in contact with the upper surface of the electron supply layer 16. The source electrode 3S and the drain electrode 3D are in Ohmic contact with the electron supply layer 16.

An insulating film 21 is formed on the cap layer 17. The insulating film 21 is, for example, a silicon nitride (SiN) film. The insulating film 21 covers the source electrode 3S and the drain electrode 3D. Openings 21S, 21G, and 21D are formed in the insulating film 21. The source electrode 3S is exposed from the opening 21S, and the drain electrode 3D is exposed from the opening 21D. The opening 21G is formed between the source electrode 3S and the drain electrode 3D. The gate electrode 3G is formed on the insulating film 21 between the source electrode 3S and the drain electrode 3D, and contacts the upper surface 20A of the stacked structure 20 through the opening 21G. The gate electrode 3G is in Schottky contact with the stacked structure 20. The opening 21G and the gate electrode 3G may be closer to the source electrode 3S than to the drain electrode 3D.

A through-hole 5 is formed in the substrate 10 and the stacked structure 20. The through-hole 5 penetrates the substrate 10 and the stacked structure 20, and reaches the source electrode 3S. The rear-surface electrode 4 is formed on the lower surface 10B of the substrate 10. The rear-surface electrode 4 is in contact with the lower surface 10B, and is in contact with the source electrode 3S via the through-hole 5. The source electrode 3S and the rear-surface electrode 4 are electrically connected to each other. If the source electrode 3S and the rear-surface electrode 4 are electrically connected to each other, the through-hole 5 may be formed at a position apart from the source electrode 3S, and the rear-surface electrode 4 may be in no direct contact with the source electrode 3S.

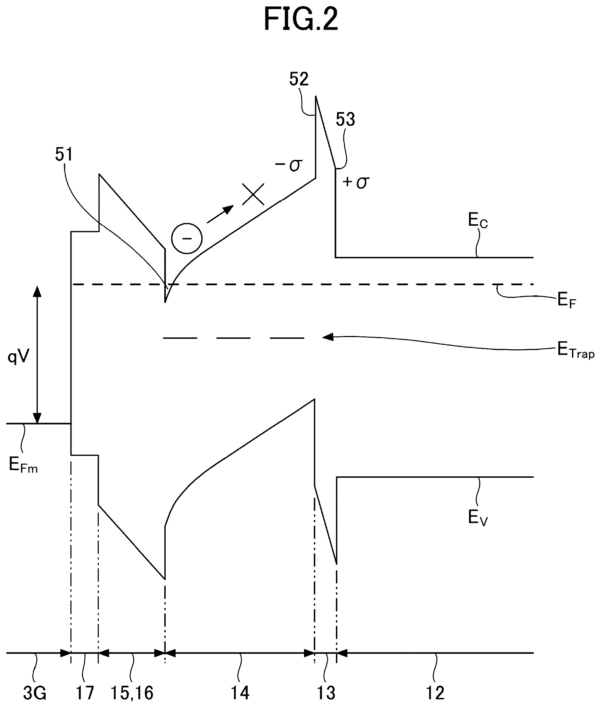

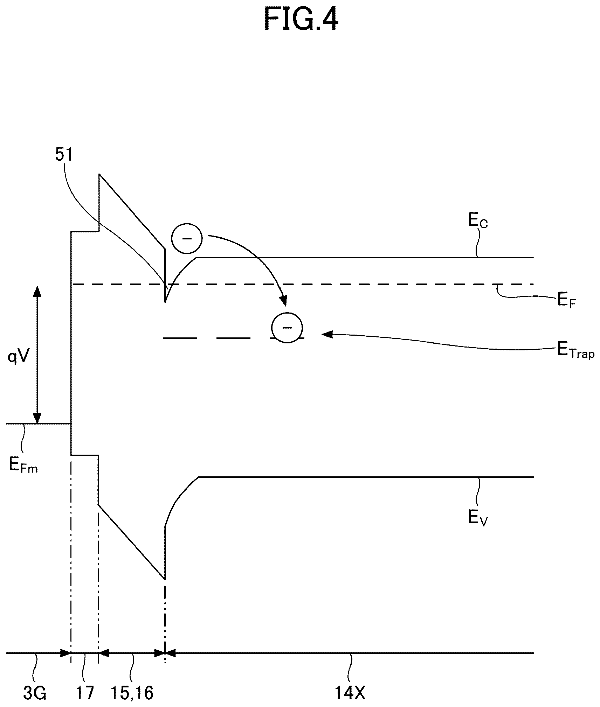

Here, a band structure of the buffer layer 12, the barrier layer 13, the electron traveling layer 14, the spacer layer 15, the electron supply layer 16, and the cap layer 17 will be described. FIG. 2 is a band diagram illustrating the band structure of the buffer layer 12, the barrier layer 13, the electron traveling layer 14, the spacer layer 15, the electron supply layer 16, and the cap layer 17 in the embodiment. FIG. 2 illustrates the band structure obtained when voltage V is applied to the gate electrode 3G. In FIG. 2, E_{Fm} is a Fermi level of the gate electrode 3G, E_{F} is a Fermi level of the stacked structure 20, E_{Trap} is a trap level in the electron traveling layer 14, E_{C} is the lower end of a conduction band, and E_{V} is the upper end of a valence band. The same applies to FIG. 4 described below.

As illustrated in FIG. 2, a region where the lower end E_{C} of the conduction band is lower than the Fermi level E_{F} is present near the upper surface of the electron traveling layer 14. In this region, two-dimensional electron gas (2DEG) 51 is present. Also, the band gap of the barrier layer 13 is larger than the band gap of the buffer layer 12 and the band gap of the electron traveling layer 14. Therefore, negative polarization charges (-σ) 52 are present near the interface between the barrier layer 13 and the electron traveling layer 14, and positive polarization charges (+σ) 53 are present near the interface between the barrier layer 13 and the buffer layer 12. Also, in the electron traveling layer 14, the lower end E_{C} of the conduction band is higher at a position closer to the barrier layer 13. Therefore, in the present embodiment, even if the electrons in the 2DEG 51 have high energy, the negative polarization charges 52 prevent movement of the electrons in the 2DEG 51 toward a deep position in the electron traveling layer 14. Therefore, even if the trap level E_{Trap} is present in the electron traveling layer 14, the electrons are not readily trapped at the trap level E_{Trap}, and transient response performance can be increased.

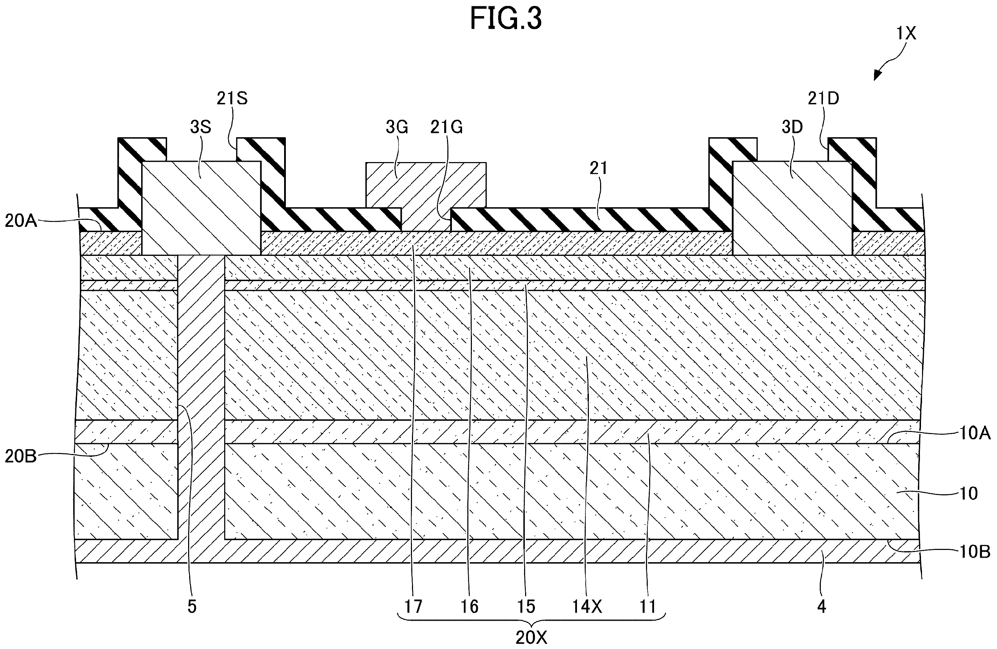

Next, a reference example will be described for comparison with the embodiment. FIG. 3 is a cross-sectional view illustrating a semiconductor device according to the reference example, not falling under the scope of the claims.

As illustrated in FIG. 3, a semiconductor device 1X according to the reference example includes a stacked structure 20X instead of the stacked structure 20. The stacked structure 20X includes an electron traveling layer 14X instead of the buffer layer 12, the barrier layer 13, and the electron traveling layer 14. The electron traveling layer 14X is, for example, an undoped GaN layer having a thickness of 400 nm. The configuration of the semiconductor device 1X is otherwise the same as the configuration of the semiconductor device 1.

Here, a band structure of the electron traveling layer 14X, the spacer layer 15, the electron supply layer 16, and the cap layer 17 will be described. FIG. 4 is a band diagram illustrating the band structure of the electron traveling layer 14X, the spacer layer 15, the electron supply layer 16, and the cap layer 17 in the reference example, not falling under the scope of the claims.

As illustrated in FIG. 4, similar to the embodiment, the 2DEG 51 is present in the reference example. However, because the barrier layer 13 is not provided, the negative polarization charges (-σ) 52 and the positive polarization charges (+σ) 53 are absent. Thus, the lower end E_{C} of the conduction band is constant in the electron traveling layer 14X. Therefore, when the electrons in the 2DEG 51 have high energy, the electrons in the 2DEG 51 tend to move toward a deep position in the electron traveling layer 14X, and to be trapped at the trap level E_{Trap} in the electron traveling layer 14X. Therefore, transient response performance can be degraded due to trapping of the electrons.

In this way, according to the present embodiment, by the presence of the barrier layer 13, the transient response performance can be increased compared to the transient response performance in the reference example. Also, because the transient response performance can be increased by the presence of the barrier layer 13, the buffer layer 12 does not need to be thin to an extent causing reduction in the crystallinity of the barrier layer 13, the electron traveling layer 14, the spacer layer 15, the electron supply layer 16, and the cap layer 17. Therefore, it is possible to increase transient response performance while avoiding reduction in crystallinity.

Moreover, because the buffer layer 12 may be relatively thick, the through-hole 5 is readily formed in a short time as described below. For formation of the through-hole 5, the stacked structure 20 is etched after etching of the substrate 10. Because the substrate 10 is much thicker than the stacked structure 20, it is preferable to perform etching of the substrate 10 at a high etching rate. However, if excessive over-etching is performed upon the etching of the substrate 10, the source electrode 3S may also be etched. Although lowering the etching rate can avoid such excessive over-etching, in this case, the formation of the through-hole 5 takes a longer time. With respect to the above, when the buffer layer 12 is relatively thick, etching of the source electrode 3S due to over-etching can be avoided. Therefore, the substrate 10 can be etched at a high etching rate, and the through-hole 5 is readily formed in a short time.

According to the invention, the barrier layer 13 may not be the AlN layer, and is an AlₓIn_{y}Ga_{1-x-y}N layer (0 < x ≤ 1, 0 ≤ y ≤ 0.1). In this case as well, the band gap of the barrier layer 13 tends to be larger than the band gap of the buffer layer 12 and the band gap of the electron traveling layer 14. Note that, the composition of the AlₓIn_{y}Ga_{1-x-y}N layer may be a composition in which the polarization charges 52 and 53 equal to or more than in the case of using an AlₓGa₁₋ₓN layer (0.8 ≤ x ≤ 1) are obtained. For example, the relation of "y + 0.8 ≤ x" may be established. In this case, polarization charges 52 and 53 are more readily sufficiently obtained.

The thickness of the barrier layer 13 may be 2 nm or larger and 20 nm or smaller. When the thickness of the barrier layer 13 is 2 nm or larger, polarization charges are more readily sufficiently obtained. When the thickness of the barrier layer 13 is 20 nm or smaller, the barrier layer 13 is more readily pseudo-lattice matched with the buffer layer 12. The thickness of the barrier layer 13 may be 3 nm or larger and 18 nm or smaller and may be 5 nm or larger and 15 nm or smaller.

The barrier layer 13 may be an Al_{0.8}Ga_{0.2}N layer having a thickness of 3 nm.

The thickness of the buffer layer 12 is 200 nm or larger. When the thickness of the buffer layer 12 is 200 nm or larger, favorable crystallinity is more readily obtained in the barrier layer 13, the electron traveling layer 14, the spacer layer 15, the electron supply layer 16, and the cap layer 17. The thickness of the buffer layer 12 may be 300 nm or larger or may be 400 nm or larger. The upper limit of the thickness of the buffer layer 12 is 20 µm or smaller, may be 10 µm or smaller, or may be 1 µm or smaller. When the buffer layer 12 is too thick, it tends to take a longer time to form the buffer layer 12 and the through-hole 5.

The thickness of the electron traveling layer 14 is 400 nm or smaller. When the thickness of the electron traveling layer 14 is 400 nm or smaller, the entirety of the electron traveling layer 14 is more readily influenced by the polarization charges 52. The thickness of the electron traveling layer 14 may be 350 nm or smaller or may be 300 nm or smaller. The lower limit of the thickness of the electron traveling layer 14 is 200 nm or larger, may be 250 nm or larger, or may be 300 nm or larger. When the electron traveling layer 14 is too thin, the current flowing through the semiconductor device 1 tends to be reduced.

The electron traveling layer 14 is 400 nm and the thickness of the buffer layer 12 may be 400 nm or larger and 20 µm or smaller. In this case, compared to a configuration in which the buffer layer 12 and the barrier layer 13 are not provided, favorable crystallinity is more readily obtained in the electron traveling layer 14, the spacer layer 15, the electron supply layer 16, and the cap layer 17.

The thickness of the buffer layer 12 is 400 nm and the thickness of the electron traveling layer 14 is 200 nm or larger and 400 nm or smaller. In this case, compared to the configuration in which the buffer layer 12 and the barrier layer 13 are not provided, movement of the electrons in the 2DEG 51 toward a deep position in the electron traveling layer 14 is more readily prevented. Also, by the presence of the polarization charges 52, a strong electric field is more readily applied to the entirety of the electron traveling layer 14. Therefore, transient response performance is more readily increased.

For example, the thickness of the buffer layer 12 may be greater than the thickness of the electron traveling layer 14 by a factor that is greater than 1 and that is less than or equal to 100.

While embodiments of the present disclosure have been described in detail, the present disclosure should not be construed as being limited to the specific embodiments. Various modifications and alterations are possible within the scope of claims as recited.

### REFERENCE SINGS LIST

1,1X: semiconductor device
3D: drain electrode
3G: gate electrode
3S: source electrode
4: rear-surface electrode
5: through-hole
10: substrate
10A: upper surface
10B: lower surface
11: initial layer
12: buffer layer
13: barrier layer
14,14X: electron traveling layer
15: spacer layer
16: electron supply layer
17: cap layer
20,20X: stacked structure
20A: upper surface
20B: lower surface
21: insulating film
21D: opening
21G: opening
21S: opening
51: two-dimensional electron gas (2DEG)
52,53: polarization charge

## Claims

1. A semiconductor device, comprising:
a substrate (10);
an initial layer (11) is an aluminum nitride (AIN) layer on the substrate (10);
a buffer layer (12) is an undoped GaN layer on the initial layer (11);
a barrier layer (13) is an AlₓIn_{y}Ga_{1-x-y}N layer (with 0 < x ≤ 1, 0 ≤ y ≤ 0.1) on the buffer layer (12);
an electron traveling layer (14) is an undoped GaN layer on the barrier layer (13);
a spacer layer (15) is an undoped aluminum gallium nitride (AlGaN) layer having a thickness of 2 nm or larger and 10 nm or smaller on the electron traveling layer (14); and
an electron supply layer (16) is a n-type AlGaN layer on the spacer layer (15), wherein:
the electron traveling layer (16) is thinner than the buffer layer (12);
a band gap of the barrier layer (13) is larger than a band gap of the buffer layer (12) and a band gap of the electron traveling layer (14);
a thickness of the initial layer (11) is 5 nm or larger and 100 nm or smaller,
a thickness of the electron supply layer (16) is 5 nm or larger and 28 nm or smaller,
a thickness of the buffer layer (12) is 200 nm or larger and 20 µm or smaller; and
a thickness of the electron traveling layer (14) is 200 nm or larger and 400 nm or smaller.

2. The semiconductor device according to claim 1, wherein a relation of "y + 0.8 ≤ x" is established.

3. The semiconductor device according to claim 1 or claim 2, wherein a thickness of the barrier layer (13) is 2 nm or larger and 20 nm or smaller.

4. The semiconductor device according to any one of claims 1 to 3, further comprising a cap layer (17) which is a n-type GaN layer having a thickness of 1 nm or larger and 10 nm or smaller on the electron supply layer (16).

## Patentansprüche

1. Halbleiteranordnung, umfassend:
ein Substrat (10);
eine Initialschicht (11), die eine Aluminiumnitrid(AIN)-Schicht auf dem Substrat (10) ist;
eine Pufferschicht (12), die eine undotierte GaN-Schicht auf der Initialschicht (11) ist;
eine Barriereschicht (13), die eine AlₓIn_{y}Ga_{1-x-y}N-Schicht (wobei 0 < x ≤ 1, 0 ≤ y ≤ 0,1) auf der Pufferschicht (12) ist;
eine Elektronentransportschicht (14), die eine undotierte GaN-Schicht auf der Barriereschicht (13) ist;
eine Abstandsschicht (15), die eine undotierte Aluminiumgalliumnitrid(AlGaN)-Schicht mit einer Dicke von 2 nm oder mehr und 10 nm oder weniger auf der Elektronentransportschicht (14) ist; und
eine Elektronenzufuhrschicht (16), die eine n-dotierte AlGaN-Schicht auf der Abstandsschicht (15) ist, wobei:
die Elektronentransportschicht (16) dünner als die Pufferschicht (12) ist;
eine Bandlücke der Barriereschicht (13) größer als eine Bandlücke der Pufferschicht (12) und eine Bandlücke der Elektronentransportschicht (14) ist;
eine Dicke der Initialschicht (11) 5 nm oder mehr und 100 nm oder weniger beträgt,
eine Dicke der Elektronenzufuhrschicht (16) 5 nm oder mehr und 28 nm oder weniger beträgt,
eine Dicke der Pufferschicht (12) 200 nm oder mehr und 20 µm oder weniger beträgt; und
eine Dicke der Elektronentransportschicht (14) 200 nm oder mehr und 400 nm oder weniger beträgt.

2. Halbleiteranordnung nach Anspruch 1, wobei eine Beziehung "y + 0,8 ≤ x" erfüllt ist.

3. Halbleiteranordnung nach Anspruch 1 oder Anspruch 2, wobei eine Dicke der Barriereschicht (13) 2 nm oder mehr und 20 nm oder weniger beträgt.

4. Halbleiteranordnung nach einem der Ansprüche 1 bis 3, ferner umfassend eine Deckschicht (17), die eine n-dotierte GaN-Schicht mit einer Dicke von 1 nm oder mehr und 10 nm oder weniger auf der Elektronenzufuhrschicht (16) ist.

## Revendications

1. Dispositif semi-conducteur, comprenant :
un substrat (10) ;
une couche initiale (11) qui est une couche de nitrure d'aluminium (AIN) sur le substrat (10) ;
une couche tampon (12) qui est une couche de GaN non dopée sur la couche initiale (11) ;
une couche barrière (13) qui est une couche d'AlₓIn_{y}Ga_{1-x-y}N (avec 0 < x ≤ 1, 0 ≤ y ≤ 0,1) sur la couche tampon (12) ;
une couche de transport d'électrons (14) qui est une couche de GaN non dopée sur la couche barrière (13) ;
une couche d'espacement (15) qui est une couche de nitrure d'aluminium-gallium (AlGaN) non dopée ayant une épaisseur de 2 nm ou plus et de 10 nm ou moins sur la couche de transport d'électrons (14) ; et
une couche d'alimentation en électrons (16) qui est une couche d'AlGaN de type n sur la couche d'espacement (15), dans lequel :
la couche de transport d'électrons (16) est plus mince que la couche tampon (12) ;
une largeur de bande interdite de la couche barrière (13) est supérieure à une largeur de bande interdite de la couche tampon (12) et à une largeur de bande interdite de la couche de transport d'électrons (14) ;
une épaisseur de la couche initiale (11) est de 5 nm ou plus et de 100 nm ou moins,
une épaisseur de la couche d'alimentation en électrons (16) est de 5 nm ou plus et de 28 nm ou moins,
une épaisseur de la couche tampon (12) est de 200 nm ou plus et de 20 µm ou moins ; et
une épaisseur de la couche de transport d'électrons (14) est de 200 nm ou plus et de 400 nm ou moins.

2. Dispositif semi-conducteur selon la revendication 1, dans lequel une relation « y + 0,8 ≤ x » est satisfaite.

3. Dispositif semi-conducteur selon la revendication 1 ou la revendication 2, dans lequel une épaisseur de la couche barrière (13) est de 2 nm ou plus et de 20 nm ou moins.

4. Dispositif semi-conducteur selon l'une quelconque des revendications 1 à 3, comprenant en outre une couche de capuchon (17) qui est une couche de GaN de type n ayant une épaisseur de 1 nm ou plus et de 10 nm ou moins sur la couche d'alimentation en électrons (16).
